# EUROPEAN PATENT APPLICATION

(11) **EP 4 844 455 A1**
(43) Date of publication of application: **25.11.2026**
(21) Application number: 25186530.9
(22) Date of filing: 01.07.2025
(51) Int. Cl.: G01W 1/10, G06F 30/27, G06N 3/02, G06N 3/08

(54) **WIND SPEED DATA PREDICTION METHOD AND APPARATUS, ELECTRONIC DEVICE, AND STORAGE MEDIUM**

(30) Priority: 21.05.2025 CN 202510667380
(71) Applicant: The Hong Kong Polytechnic University Shenzhen Research Institute, Shenzhen, Guangdong 518057 (CN)
(72) Inventor: CHEN, Zhengwei, Shenzhen, 518057 (CN); LU, Jiahao, Shenzhen, 518057 (CN); GUO, Zhanhao, Shenzhen, 518057 (CN)
(74) Representative: IPrime Rentsch Kaelin AG

(57) **Abstract**

A wind speed data prediction method includes: acquiring three-dimensional spatial coordinates of wind speed stations in a prediction scenario, and constructing a continuous spatio-temporal graph sequence based on the three-dimensional spatial coordinates, where the continuous spatio-temporal graph sequence includes an adjacency matrix, and does not include wind speed station data of a missing wind speed station; inputting the continuous spatio-temporal graph sequence into a spatio-temporal graph attention network, sequentially performing node relationship attention processing on the wind speed station data of the missing wind speed station based on the weight adjacency elements through graph attention layers cascaded to obtain a complete spatio-temporal graph sequence, where the complete spatio-temporal graph sequence includes the wind speed station data of the missing wind speed station; and inputting the complete spatio-temporal graph sequence into a wind speed prediction model to obtain a wind speed data prediction result of the prediction scenario.

## Description

### TECHNICAL FIELD

The present disclosure relates to the technical field of data processing, and in particular, to a wind speed data prediction method and apparatus, an electronic device, and a storage medium.

### BACKGROUND

Wind speed data prediction involves a process of estimating and predicting future wind speed through various methods and models by using historical wind speed data and related meteorological data. In the related art, for wind speed data prediction in complex prediction scenarios (e.g., railway environment), become some detection data may be missing, a spatial interpolation method (e.g., Kriging interpolation, inverse distance weighting method, a nearest neighbor averaging method, etc.) is generally used to complete the missing data, and then wind speed prediction is performed using conventional time series modeling (e.g., ARIMA, autoregressive moving average, LSTM, etc.). However, these reconstruction and prediction methods focus on only the time dimension data or the space dimension, and cannot effectively capture the complex dynamic spatio-temporal dependencies between measurement stations in the wind speed field, resulting in inaccurate wind speed prediction for complex prediction scenarios.

### SUMMARY

Embodiments of the present disclosure provide a wind speed data prediction method and apparatus, an electronic device, and a storage medium, to improve the accuracy of wind speed prediction in complex prediction scenarios.

To achieve the above objective, in accordance with a first aspect of the present disclosure, an embodiment provides a wind speed data prediction method, including:
acquiring three-dimensional spatial coordinates of a plurality of wind speed stations in a prediction scenario, and constructing a continuous spatio-temporal graph sequence in the prediction scenario based on the plurality of three-dimensional spatial coordinates, where the continuous spatio-temporal graph sequence includes an adjacency matrix, the continuous spatio-temporal graph sequence does not include wind speed station data of a missing wind speed station, and the adjacency matrix includes weight adjacency elements between the missing wind speed station and other wind speed stations;
inputting the continuous spatio-temporal graph sequence into a spatio-temporal graph attention network, and sequentially performing node relationship attention processing on the wind speed station data of the missing wind speed station based on the weight adjacency elements through a plurality of graph attention layers cascaded to obtain a complete spatio-temporal graph sequence, where the complete spatio-temporal graph sequence includes the wind speed station data of the missing wind speed station; and
inputting the complete spatio-temporal graph sequence into a wind speed prediction model for data processing to obtain a wind speed data prediction result of the prediction scenario.

**In** some embodiments, constructing a continuous spatio-temporal graph sequence in the prediction scenario based on the plurality of three-dimensional spatial coordinates includes:
performing a weighted summation operation based on the three-dimensional spatial coordinates and directional weights of every two of the wind speed stations to obtain edge features between every two of the wind speed stations;
performing percentage processing on differences between the three-dimensional spatial coordinates of every two of the wind speed stations to obtain graph connection thresholds; and
obtaining the continuous spatio-temporal graph sequence based on the graph connection thresholds and the edge features.

In some embodiments, obtaining the continuous spatio-temporal graph sequence based on the graph connection thresholds and the edge features includes:
in response to the differences between the three-dimensional spatial coordinates of every two of the wind speed stations respectively not exceeding the graph connection thresholds, obtaining the weight adjacency elements of every two of the wind speed stations based on reciprocals of the edge features, and combining all of the weight adjacency elements to obtain an adjacency matrix;
obtaining a degree matrix based on a sum of elements of each column in the adjacency matrix;
performing normalization processing based on the degree matrix to obtain a graph structure; and
combining graph structures corresponding to a plurality of consecutive moments to obtain the continuous spatio-temporal graph sequence.

In some embodiments, a process of training the spatio-temporal graph attention network includes:
acquiring a plurality of training spatio-temporal graph sequences, where each of the training spatio-temporal graph sequences includes data of a plurality of stations, missing station data, an adjacency weight matrix between a missing station and other stations, and station label data corresponding to the missing station data;
generating a node feature vector based on the missing station data, and constructing a node feature update function of each of the graph attention layers in the spatio-temporal graph attention network based on the node feature vector, the adjacency matrix, and an attention parameter of the spatio-temporal graph attention network;
constructing a loss function based on a data difference between the node feature vector and the station label data; and
iteratively updating a network parameter of the spatio-temporal graph attention network and the node feature vector based on the node feature update function and the loss function, where the network parameter updated by multiple iterations is used for node relationship attention processing on the continuous spatio-temporal graph sequence.

In some embodiments, generating a node feature vector based on the missing station data, and constructing a node feature update function of each of the graph attention layers in the spatio-temporal graph attention network based on the node feature vector, the adjacency matrix, and an attention parameter of the spatio-temporal graph attention network includes:
calculating a sum of the attention parameter between the missing station and each other station, and multiplying the sum by the adjacency weight matrix and the node feature vector of a previous graph attention layer to obtain a node feature update term; and
performing activation function processing based on the node feature update item to obtain the node feature update function of a current graph attention layer.

In some embodiments, constructing a loss function based on a data difference between the node feature vector and the station label data includes:
multiplying a 2-norm of an edge weight matrix between nodes by a regularization coefficient to obtain an edge weight norm;
performing averaging processing on 2-norms of all the data differences to obtain a data difference norm; and
accumulating the edge weight norm and the data difference norm to obtain the loss function.

In some embodiments, iteratively updating a network parameter of the spatio-temporal graph attention network and the node feature vector based on the node feature update function and the loss function includes:
performing relational attention processing on input data using the node feature update function of the graph attention layer to obtain output data, where input data of the first graph attention layer is the node feature vector, input data of each of graph attention layers other than the first graph attention layer is output data of a graph attention layer previous to the each of graph attention layers, and output data of the last graph attention layer is reconstructed station data of the missing station; and
updating the network parameter of the graph attention layer based on the output data and the loss function.

In some embodiments, inputting the complete spatio-temporal graph sequence into a wind speed prediction model for data processing to obtain a wind speed data prediction result of the prediction scenario includes:
decomposing the complete spatio-temporal graph sequence in the wind speed prediction model by a wavelet transform, followed by respective addition of placeholders at ends of sequences obtained from the decomposition, to obtain a trend component and a frequency component;
performing embedding processing on the trend component and the frequency component to obtain an embedded node feature, and obtaining graph structure data based on the embedded node feature and an embedded edge feature; and
inputting the graph structure data into a graph neural network for forward propagation processing to obtain the wind speed data prediction result.

To achieve the above objective, in accordance with a second aspect of the present disclosure, an embodiment provides an electronic device, including a memory and a processor, where the memory is configured for storing a computer program, and where the computer program, when executed by the processor, implements the wind speed data prediction method in accordance with the first aspect.

To achieve the above objective, in accordance with a third aspect of the present disclosure, an embodiment provides a storage medium, which is computer-readable storage medium and stores a computer program which, when executed by a processor, causes the processor to implement the wind speed data prediction method in accordance with the first aspect.

Embodiments of the present disclosure provide a wind speed data prediction method and apparatus, an electronic device, and a storage medium. The method includes: first, acquiring three-dimensional spatial coordinates of a plurality of wind speed stations in a prediction scenario, and constructing a continuous spatio-temporal graph sequence in the prediction scenario based on the plurality of three-dimensional spatial coordinates, where the continuous spatio-temporal graph sequence includes an adjacency matrix, the continuous spatio-temporal graph sequence does not include wind speed station data of a missing wind speed station, and the adjacency matrix includes weight adjacency elements between the missing wind speed station and other wind speed stations; then, inputting the continuous spatio-temporal graph sequence into a spatio-temporal graph attention network, and sequentially performing node relationship attention processing on the wind speed station data of the missing wind speed station based on the weight adjacency elements through a plurality of graph attention layers cascaded to obtain a complete spatio-temporal graph sequence, where the complete spatio-temporal graph sequence includes the wind speed station data of the missing wind speed station; and finally, inputting the complete spatio-temporal graph sequence into a wind speed prediction model for data processing to obtain a wind speed data prediction result of the prediction scenario. In the embodiments of the present disclosure, a spatial topological relationship between wind speed stations and potential influence intensity of each wind speed station can be determined from the initial stage by constructing a continuous spatio-temporal graph sequence including weight adjacency elements, thereby laying a structuring foundation for subsequent processing. Then, a spatio-temporal graph attention network is used to process a sequence including missing data, and wind speed data of a missing station can be reconstructed with high precision by intelligently and dynamically learning and utilizing data of known stations and a spatio-temporal correlation between the known stations by means of a node relationship attention mechanism of a plurality of graph attention layers. This scheme is far superior to a conventional spatial interpolation method that only relies on a fixed spatial distance or statistical characteristic, and can obtain a more realistic and complete spatio-temporal graph sequence. Afterward, the high-quality complete spatio-temporal graph sequence is inputted into a subsequent wind speed prediction model, so that the prediction model can learn and infer based on more comprehensive and accurate spatio-temporal dependency information, thereby overcoming the deficiencies of the existing technology in processing missing data and capturing a complex dynamic spatio-temporal dependency, and significantly improving the accuracy of wind speed data prediction in complex prediction scenarios (e.g., a railway environment).

Additional features and advantages of the present disclosure will be set forth in the description which follows, and in part will be obvious from the description, or may be learned by the practice of the present disclosure. The objects and other advantages of the present disclosure can be realized and obtained by the structures particularly pointed out in the description, claims and drawings.

### BRIEF DESCRIPTION OF DRAWINGS

FIG. 1 is a flowchart of a wind speed data prediction method according to an embodiment of the present disclosure.
FIG. 2 is a flowchart of step 101 in FIG. 1.
FIG. 3 is a flowchart of step 203 in FIG. 2.
FIG. 4 is a schematic diagram of a distributed station coordinate map structuring and graph embedding framework according to another embodiment of the present disclosure.
FIG. 5 is a flowchart of training of a spatio-temporal graph attention network according to another embodiment of the present disclosure.
FIG. 6 is a flowchart of step 502 in FIG. 5.
FIG. 7 is a flowchart of step 503 in FIG. 5.
FIG. 8 is a flowchart of step 504 in FIG. 5.
FIG. 9 is a schematic diagram of a structural framework of a spatio-temporal graph attention reconstruction model according to another embodiment of the present disclosure.
FIG. 10 is a schematic diagram of performance simulation of a first spatio-temporal graph attention reconstruction model according to another embodiment of the present disclosure.
FIG. 11 is a schematic diagram of performance simulation of a second spatio-temporal graph attention reconstruction model according to another embodiment of the present disclosure.
FIG. 12 is a schematic diagram of performance simulation of a third spatio-temporal graph attention reconstruction model according to another embodiment of the present disclosure.
FIG. 13 is a schematic diagram of performance simulation of a fourth spatio-temporal graph attention reconstruction model according to another embodiment of the present disclosure.
FIG. 14 is a schematic diagram of performance simulation of a fifth spatio-temporal graph attention reconstruction model according to another embodiment of the present disclosure.
FIG. 15 is a schematic diagram of performance simulation of a sixth spatio-temporal graph attention reconstruction model according to another embodiment of the present disclosure.
FIG. 16 is a schematic diagram of performance simulation of a seventh spatio-temporal graph attention reconstruction model according to another embodiment of the present disclosure.
FIG. 17 is a flowchart of step 103 in FIG. 1.
FIG. 18 is a schematic diagram of a structural framework of a wind speed prediction model based on a spatio-temporal graph sequence according to another embodiment of the present disclosure.
FIG. 19 is a schematic diagram of performance simulation of a first wind speed prediction model based on a spatio-temporal graph sequence according to another embodiment of the present disclosure.
FIG. 20 is a schematic diagram of performance simulation of a second wind speed prediction model based on a spatio-temporal graph sequence according to another embodiment of the present disclosure.
FIG. 21 is a schematic diagram of performance simulation of a third wind speed prediction model based on a spatio-temporal graph sequence according to another embodiment of the present disclosure.
FIG. 22 is a schematic diagram of performance simulation of a fourth wind speed prediction model based on a spatio-temporal graph sequence according to another embodiment of the present disclosure.
FIG. 23 is a schematic flowchart of wind speed data prediction in a prediction scenario according to another embodiment of the present disclosure.
FIG. 24 is a schematic structural diagram of hardware of an electronic device according to another embodiment of the present disclosure.

### DETAILED DESCRIPTION

To make the objectives, technical schemes, and advantages of the present disclosure clearer, the present disclosure is described in further detail in conjunction with accompanying drawings and embodiments. It should be understood that the specific embodiments described herein are merely used for illustrating the present disclosure, and are not intended to limit the present disclosure.

It should be noted that although functional modules have been divided in the schematic diagrams of apparatuses and logical orders have been shown in the flowcharts, in some cases, the modules may be divided in a different manner, or the steps shown or described may be executed in an order different from the orders as shown in the flowcharts. The terms such as "first," "second" and the like in the description, the claims, and the accompanying drawings are used to distinguish similar objects, and are not necessarily used to describe a specific sequence or a precedence order.

Unless otherwise defined, meanings of all technical and scientific terms used in this specification are the same as those usually understood by those having ordinary skills in the art to which the present disclosure belongs. Terms used in this specification are merely intended to describe objectives of the embodiments of the present disclosure, but are not intended to limit the present disclosure.

Wind speed data prediction involves a process of estimating and predicting future wind speed through various methods and models by using historical wind speed data and related meteorological data. In the related art, for wind speed data prediction in complex prediction scenarios (e.g., railway environment), become some detection data may be missing, a spatial interpolation method (e.g., Kriging interpolation, inverse distance weighting method, a nearest neighbor averaging method, etc.) is generally used to complete the missing data, and then wind speed prediction is performed using conventional time series modeling (e.g., ARIMA, autoregressive moving average, LSTM, etc.). However, these reconstruction and prediction methods focus on only the time dimension data or the space dimension, and cannot effectively capture the complex dynamic spatio-temporal dependencies between measurement stations in the wind speed field, resulting in inaccurate wind speed prediction for complex prediction scenarios.

To improve the accuracy of wind speed prediction in complex prediction scenarios, in the embodiments of the present disclosure, a spatial topological relationship between wind speed stations and potential influence intensity of each wind speed station can be determined from the initial stage by constructing a continuous spatio-temporal graph sequence including weight adjacency elements, thereby laying a structuring foundation for subsequent processing. Then, a spatio-temporal graph attention network is used to process a sequence including missing data, and wind speed data of a missing station can be reconstructed with high precision by intelligently and dynamically learning and utilizing data of known stations and a spatio-temporal correlation between the known stations by means of a node relationship attention mechanism of a plurality of graph attention layers. This scheme is far superior to a conventional spatial interpolation method that only relies on a fixed spatial distance or statistical characteristic, and can obtain a more realistic and complete spatio-temporal graph sequence. Afterward, the high-quality complete spatio-temporal graph sequence is inputted into a subsequent wind speed prediction model, so that the prediction model can learn and infer based on more comprehensive and accurate spatio-temporal dependency information, thereby overcoming the deficiencies of the existing technology in processing missing data and capturing a complex dynamic spatio-temporal dependency, and significantly improving the accuracy of wind speed data prediction in complex prediction scenarios (e.g., a railway environment).

The wind speed data prediction method and apparatus, the electronic device, and the storage medium provided in the embodiments of the present disclosure will be described below. The wind speed data prediction method provided in the embodiments of the present disclosure can be applied to any server, computing processor, or the like having computing resources.

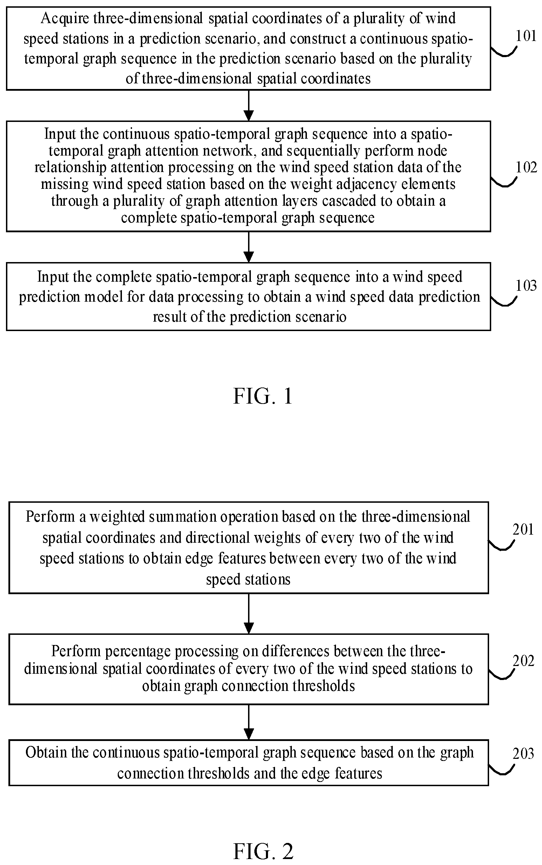

The wind speed data prediction method in the embodiments of the present disclosure will be described below. FIG. 1 is an optional flowchart of a wind speed data prediction method according to an embodiment of the present disclosure. The method in FIG. 1 may include, but is not limited to, the following steps 101 to 103. It can be understood that the order of steps 101 to 103 in FIG. 1 is not particularly limited in this embodiment, and the order of the steps may be adjusted or some steps may be omitted or added according to actual requirements.

At step 101, three-dimensional spatial coordinates of a plurality of wind speed stations in a prediction scenario are acquired, and a continuous spatio-temporal graph sequence in the prediction scenario is constructed based on the plurality of three-dimensional spatial coordinates.

Step 101 will be described in detail below.

In some embodiments, in response to a wind field data prediction request for a prediction scenario, three-dimensional spatial coordinates and measured wind speed data of a plurality of wind speed stations distributed in the prediction scenario are first acquired. The three-dimensional spatial coordinates generally include key geographical location information such as longitude, latitude, and altitude of each station. Equivalent latitude and longitude of the station are respectively defined as x and y directions, and the altitude of a wind speed measurement station relative to ground is defined as z direction. Each wind speed measurement station is represented as a node in a graph, and each node has three-dimensional coordinate features (longitude, latitude, and height) corresponding to three-dimensional spatial coordinates.

A structured data representation in the prediction scenario, i.e., a continuous spatio-temporal graph sequence, will be further constructed based on the accurate three-dimensional spatial coordinates of the plurality of wind speed stations. The continuous spatio-temporal graph sequence refers to a series of graph structures evolving over time, where each graph represents a time snapshot, each node in the graph corresponds to a wind speed station, and each edge represent a spatial relationship between stations. The key component of the continuous spatio-temporal graph sequence is an adjacency matrix, which mathematically describes the connectivity between nodes in the graph.

Because measured data of a station may be missing in complex prediction scenarios (e.g., railway scenario), the continuous spatio-temporal graph sequence in the initial construction stage does not include wind speed station data of wind speed stations whose measured data is missing. However, the design of the adjacency matrix considers this data missing case, and still includes weight adjacency elements between the missing wind speed station and other wind speed stations. These weight adjacency elements are specific values in the adjacency matrix, which quantify a preset spatial correlation strength or potential influence degree between a station whose data is missing and other stations, providing a basis for subsequent data reconstruction.

Referring to FIG. 2, constructing a continuous spatio-temporal graph sequence in the prediction scenario based on the plurality of three-dimensional spatial coordinates includes the following steps 201 to 203.

At step 201, a weighted summation operation is performed based on the three-dimensional spatial coordinates and directional weights of every two of the wind speed stations to obtain edge features between every two of the wind speed stations.

At step 202, percentage processing is performed on differences between the three-dimensional spatial coordinates of every two of the wind speed stations to obtain graph connection thresholds.

At step 203, the continuous spatio-temporal graph sequence is obtained based on the graph connection thresholds and the edge features.

Steps 201 to 203 will be described in detail below.

In some embodiments, to quantify the strength of the spatial relationship between any two wind speed stations in the prediction scenario, a weighted summation operation may be performed based on the precise three-dimensional spatial coordinates (e.g., longitude, latitude, and altitude) and preset "directional weights" of every two of the wind speed stations to obtain edge features between every two of the wind speed stations, as shown in the following formula (1). ${d}_{ij} = α \left|Δx\right| + β \left|Δy\right| + γ \left|Δz\right|$ (1)

Directional weights (α, β, γ) = (0.2, 0.2, 0.6) refer to different importance coefficients assigned to different spatial dimensions (corresponding to the influence weights of longitude, latitude, and altitude on wind speed) to reflect their differences in influence on wind speed, where the height factor has the largest weight.

Through the weighted summation operation, e.g., using a weighted Euclidean distance formula, the edge features between every two wind speed stations can be obtained, which can be used as a comprehensive measure of the spatial distance or similarity between the two stations. It is not a simple geometric distance, but a weighted result considering the influencing factors of different directions, providing basic edge attribute information for the subsequent construction of graph structures.

To determine stations for which connections should be established during the construction of graph structures, a reasonable graph connection threshold corresponding to each direction needs to be determined in advance. During the determination of the graph connection threshold corresponding to each direction, the differences between the three-dimensional spatial coordinates of every two of the wind speed stations, i.e., differences in longitude, latitude, and altitude, are calculated respectively, and then percentage processing is performed on the differences, to obtain the graph connection threshold corresponding to each direction (including longitude, latitude, and altitude), as shown in the following formulas (2) to (4). ${τ}_{z} = {Percentile}_{85 %} \left(\left|{z}_{i}-{z}_{j}\right|\right)$ (2) ${τ}_{x} = {Percentile}_{95 %} \left(\left|{x}_{i}-{x}_{j}\right|\right)$ (3) ${τ}_{y} = {Percentile}_{95 %} \left(\left|{y}_{i}-{y}_{j}\right|\right)$ (4)

Percentage processing generally refers to the use of a percentile method, e.g., selecting a difference in a particular percentile (e.g., 85% or 95%) as the connection threshold in the corresponding direction. In this way, the system can adaptively determine the tolerance of connection in different spatial dimensions according to the distribution characteristics of data, thereby obtaining one or more graph connection thresholds. In this embodiment, a 85% percentile value is used for height differences and a 95% percentile values is used for horizontal distances (longitude and latitude).

Next, the generated graph connection thresholds and edge features between every two stations are further used to finally construct a continuous spatio-temporal graph sequence in the prediction scenario, so that a graph representing the spatial structure of the wind speed field at a single time point can be constructed. Because the wind speed data changes with time, such a graph structure is constructed for each observation time point. The graph structures arranged in chronological order are combined to form a continuous spatio-temporal graph sequence, which can dynamically reflect the evolution of the wind speed field in time and space. The following will further describe how to use the graph connection thresholds and edge features between every two stations to construct a continuous spatio-temporal graph sequence in the prediction scenario.

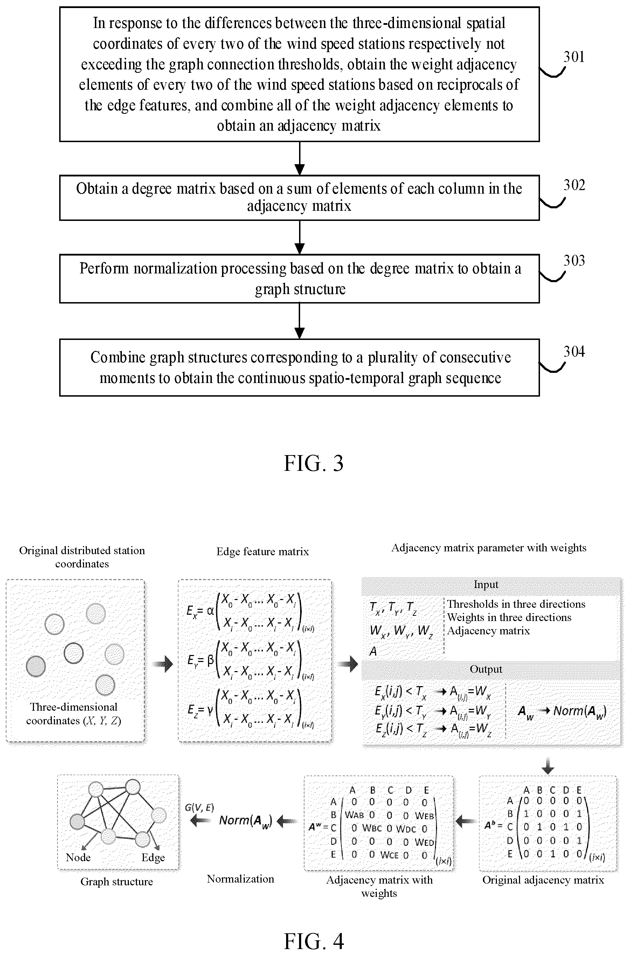

Referring to FIG. 3, obtaining the continuous spatio-temporal graph sequence based on the graph connection thresholds and the edge features includes the following steps 301 to 304.

At step 301, when the differences between the three-dimensional spatial coordinates of every two of the wind speed stations respectively do not exceed the graph connection thresholds, the weight adjacency elements of every two of the wind speed stations are obtained based on reciprocals of the edge features, and all of the weight adjacency elements are combined to obtain an adjacency matrix.

At step 302, a degree matrix is obtained based on a sum of elements of each column in the adjacency matrix.

At step 303, normalization processing is performed based on the degree matrix to obtain a graph structure.

At step 304, graph structures corresponding to a plurality of consecutive moments are combined to obtain the continuous spatio-temporal graph sequence.

Steps 301 to 304 will be described in detail below.

In some embodiments, to construct a continuous spatio-temporal graph sequence in the prediction scenario, first, an adjacency matrix with weights that corresponds to graphs in the prediction scenario needs to be constructed. During the construction of the adjacency matrix, it is determined one by one whether the difference in each direction between the three-dimensional spatial coordinates of every two wind speed stations does not exceed a preset graph connection threshold (as shown in formulas (2) to (4)). If this condition is met, i.e., if the difference in each direction does not exceed the graph connection threshold of the corresponding direction, it indicates that the two stations are spatially close or related enough and a connection should be established for the two stations in the graph. In this case, the weight adjacency elements between the two stations are calculated based on reciprocals of the edge features between the two stations, as shown in the following formula (5). ${w}_{ij} = \left\{\begin{matrix}\frac{1}{{d}_{ij}} , & ij \left|{x}_{i}-{x}_{j}\right| \leq {τ}_{x} and \left|{y}_{i}-{y}_{j}\right| \leq {τ}_{y} and \left|{z}_{i}-{z}_{j}\right| \leq {τ}_{z} \\ 0 , & otherwise\end{matrix}\right.$ (5)

Weight adjacency elements are calculated for all station pairs that meet the condition, and the weight adjacency elements are arranged and combined according to station numbers to finally form a complete adjacency matrix W. The value of each element of the adjacency matrix W is the connection strength or weight wᵢⱼ between the corresponding two stations.

After the adjacency matrix is obtained, a degree matrix needs to be calculated for auxiliary calculation in subsequent graph structure normalization processing. It can be understood that the degree matrix is a diagonal matrix whose elements on the diagonal correspond to the degrees of nodes in the graph.

The diagonal elements in the degree matrix are obtained based on the sum of each column of elements in the adjacency matrix, as shown in the following formula (6). ${D}_{ii} = {\sum }_{j} {w}_{ij}$ (6)

For any node in the graph (i.e., the corresponding wind speed station), a diagonal element value corresponding to the node in the degree matrix is equal to the sum of the weights of all edges connected to the node in the adjacency matrix, which reflects the total connection strength or centrality of the node in the graph.

Further, to eliminate the influence of the differences in degrees of nodes in the graph and make the representation of the graph more suitable for subsequent processing by a model such as a graph neural network, normalization processing is performed on the adjacency matrix W based on the obtained degree matrix D, as shown in the following formula (7). ${A}_{norm} = {D}^{- \frac{1}{2}} ⋅ W ⋅ {D}^{\frac{1}{2}}$ (7)

Through this normalization operation, a normalized graph representation, i.e., graph structure, can be obtained. The normalized graph structure can better balance the weights of information transmission between different nodes, to improve the performance and stability of graph learning algorithms.

Because wind speed monitoring data are collected continuously at different time points, the graph structure of a single time point can only reflect the spatial distribution characteristics at that time point. Therefore, to capture the dynamic characteristic of the wind speed field evolving with time, graph structures corresponding to a plurality of consecutive moments are acquired, and the independent graph structures arranged in chronological order are serially combined to finally obtain a continuous spatio-temporal graph sequence represented by dynamic graphs, which not only includes spatial connection information corresponding to each moment, but also reflects the evolution process of these spatial structures and node attributes with time. For example, for wind speed measurement in a measurement area, a measurement window duration is 120 seconds, a total measurement duration is 90 minutes, a graph structure is formed for every second, and the original time series is converted into a spatio-temporal graph sequence.

By performing the above steps 301 to 304, the weight adjacency elements in the adjacent matrix are accurately defined through threshold-based judgment and calculation of reciprocals of the edge features, to reflect the connection strength between stations; then, the degree matrix is calculated, and normalization processing is performed based on the degree matrix to obtain a normalized graph structure, which facilitates subsequent model processing; graph structures corresponding to a plurality of time points are organically combined to form a continuous spatio-temporal sequence which can comprehensively describe the spatio-temporal dynamic characteristics of the wind speed field. This ensures that the inputted spatio-temporal graph sequence can accurately capture complex spatial dependencies and the evolution of the complex spatial dependencies with time, providing a solid data basis for subsequent missing data reconstruction and high-precision wind speed prediction.

FIG. 4 is a schematic diagram of a distributed station coordinate map structuring and graph embedding framework according to an embodiment of the present disclosure. As shown in FIG. 4, based on the three-dimensional spatial coordinates (X, Y, Z) and corresponding directional weights (α, β, γ) of the plurality of wind speed stations in the prediction scenario, edge features (Ex, Ey, Ez) between every two wind speed stations are calculated. Then, based on the inputted graph connection thresholds (Tx, Ty, Tz) and preset weights (Wx, Wy, Wz) of three directions and the calculated edge features, weight adjacency elements are determined to form an adjacency matrix with weights, and then normalization processing is performed to obtain a final graph structure, which lays a single time-step graph representation foundation for the subsequent construction of the continuous spatio-temporal graph sequence.

By performing the above steps 201 to 203, the spatial relationship between stations is more finely described by using the edge features calculated by introducing directional weights, and the graph connection thresholds are adaptively determined by performing percentage processing on the differences between the three-dimensional spatial coordinates, which makes the graph construction more robust; and then these information is comprehensively used to generate a continuous spatio-temporal graph sequence that can reflect the dynamic characteristics of the real wind speed field, which can more accurately capture the complex interaction between measurement stations in the wind speed field, and provides a solid foundation for subsequent high-precision data reconstruction and prediction, thereby improving the effectiveness and reliability of the entire prediction scheme.

At step 102, the continuous spatio-temporal graph sequence is inputted into a spatio-temporal graph attention network, and node relationship attention processing is sequentially performed on the wind speed station data of the missing wind speed station based on the weight adjacency elements through a plurality of graph attention layers cascaded to obtain a complete spatio-temporal graph sequence.

Step 102 will be described in detail below.

In some embodiments, the constructed continuous spatio-temporal graph sequence, which carries information about a network topology of the plurality of wind speed stations in the prediction scenario with data of some stations being missing, will be fed as an input into a specially designed spatio-temporal graph attention network.

The spatio-temporal graph attention network is formed by a plurality of graph attention layers cascaded, and each of the graph attention layers processes inputted graph data. A core processing process is to perform node relationship attention processing on wind speed station data of missing wind speed stations based on the weight adjacency elements defined in the adjacency matrix. The node relationship attention processing can dynamically evaluate and weight the contribution of neighboring nodes to a target missing station, thereby learning and capturing complex spatio-temporal dependencies.

By iteratively propagating and updating features through the plurality of graph attention layers cascaded, the spatio-temporal graph attention network can intelligently reconstruct missing wind speed data with high precision. The final output is a complete spatio-temporal graph sequence. The main difference between the complete spatio-temporal graph sequence and the input is that the complete spatio-temporal graph sequence includes wind speed station data of the original missing wind speed station that is obtained through network reconstruction, making the entire dataset complete in both the temporal and spatial dimensions.

To enable the actual spatio-temporal graph attention network to effectively reconstruct data of missing wind speed stations in the continuous spatio-temporal graph sequence, the spatio-temporal graph attention network needs to be trained in advance. Details will be given below.

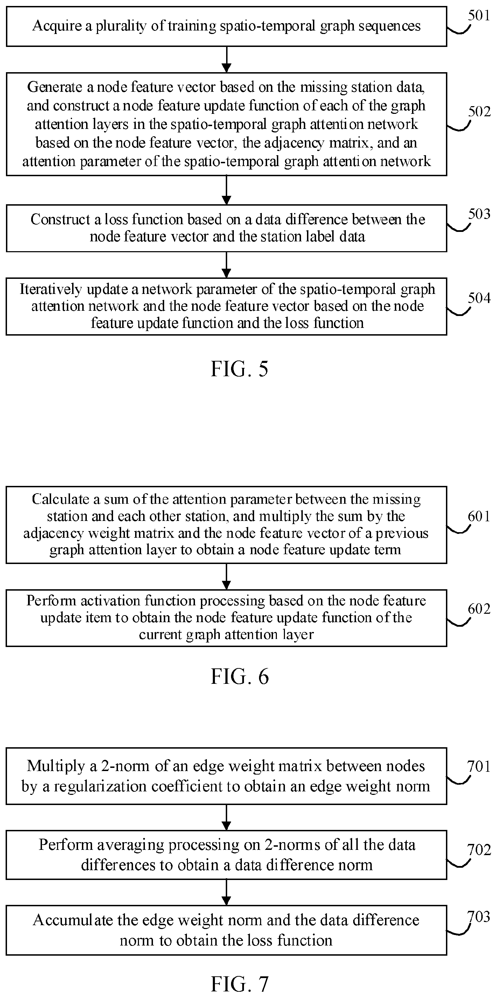

Referring to FIG. 5, a process of training the spatio-temporal graph attention network includes the following steps 501 to 504.

At step 501, a plurality of training spatio-temporal graph sequences are acquired, where each of the training spatio-temporal graph sequences includes data of a plurality of stations, missing station data, an adjacency weight matrix between a missing station and other stations, and station label data corresponding to the missing station data.

At step 502, a node feature vector based on the missing station data is generated, and a node feature update function of each of the graph attention layers in the spatio-temporal graph attention network is constructed based on the node feature vector, the adjacency matrix, and an attention parameter of the spatio-temporal graph attention network.

Steps 501 to 502 will be described in detail below.

In some embodiments, during training of the spatio-temporal graph attention network, a plurality of training spatio-temporal graph sequences need to be acquired first, to guide the spatio-temporal graph attention network to learn how to reconstruct missing information. The training spatio-temporal graph sequences each include: data of a plurality of stations, i.e., known measured values or features of all wind speed stations in the prediction scenario; missing station data corresponding to missing stations whose wind speed station data is missing, where during the training process, the missing station data is a part of data intentionally removed or masked from the complete data, and a true value of the missing station data is used as a goal of learning; an adjacency weight matrix between a missing station and other stations, where the adjacency weight matrix defines the connection relationship and strength between all nodes in the graph, and even a potential association of missing nodes whose data is missing with other stations can be reflected by the adjacency weight matrix; and station label data corresponding to important missing station data, where the label data is true, unmasked wind speed values of "missing" stations, which will be predicted or reconstructed through intensive training by the network.

Alternatively, a whole sequence of a group of nodes is randomly deleted from an original complete spatio-temporal wind speed graph sequence, and all values in the missing sequence are imputed with zero to serve as missing station data of the missing stations, which corresponds to missing data of missing wind speed stations in an actual continuous spatio-temporal graph sequence, thus obtaining a corresponding training spatio-temporal graph sequence where data of the wind speed stations is missing.

Once the training data is ready, the network begins to build its core computing mechanism. In this embodiment, a spatio-temporal graph attention network including 4+1=5 graph attention layers is used to reconstruct missing wind speed data. The input of the spatio-temporal graph attention network is an original graph sequence with missing values from a moment t-S to a moment t, where the missing sequence is imputed with zeros and labeled. The spatio-temporal graph attention network architecture includes five graph attention layers, where each layer uses a different dropout rate for regularization. A formula for calculating a graph attention parameter is shown in the following formula (8). ${α}_{ij} = softmaxj \left({e}_{ij}\right) = \frac{exp \left({e}_{ij}\right)}{{\sum }_{j ∈ N \left(i\right)} exp \left({e}_{ij}\right)}$ (8)

Therefore, during training, initial node feature vectors ${h}_{i}^{\left(0\right)}$ are generated based on inputted missing station data (usually a masked representation or initial embedding of the missing station data during training). Then, a node feature update function of each of the graph attention layers in the spatio-temporal graph attention network is constructed based on the initial node feature vectors, the adjacency matrix (which defines the spatial dependence structure between nodes), and an attention parameter αᵢⱼ in the spatio-temporal graph attention network. The node feature update function is the core of the graph attention network. It specifies how to dynamically weight features of each node and its neighboring nodes through an attention mechanism for aggregation and conversion, so as to learn a higher-level node representation in each layer of the network. How to determine the node feature update function will be further described below.

Referring to FIG. 6, constructing a node feature update function of each of the graph attention layers in the spatio-temporal graph attention network based on the node feature vector, the adjacency matrix, and an attention parameter of the spatio-temporal graph attention network includes the following steps 601 to 602.

At step 601, a sum of the attention parameter between the missing station and each other station is calculated, and the sum is multiplied by the adjacency weight matrix and the node feature vector of a previous graph attention layer to obtain a node feature update term.

At step 602, activation function processing is performed based on the node feature update item to obtain the node feature update function of the current graph attention layer.

Steps 601 to 602 will be described in detail below.

In some embodiments, to calculate a new feature representation of the missing station in each graph attention network at the current layer, a degree of influence of neighbor nodes on the missing station needs to be determined, i.e., attention parameters between the missing station and each other station are accumulated. Then, an attention weighting result obtained through accumulation is multiplied by the adjacency weight matrix (which defines the basic connection strength and structure between nodes) and the node feature vector of a previous graph attention layer (i.e., a feature representation learned by the neighbor node in the previous layer of the network) to obtain a node feature update term. Then activation function processing is performed based on the node feature update item. As such, the node feature update function of each graph attention layer is obtained, as shown in the following formula (9), ${h}_{i}^{\left(l+1\right)} = σ \left({\sum }_{j ∈ N \left(i\right)} {α}_{ij} {W}^{\left(l\right)} {h}_{j}^{\left(l\right)}\right)$ (10) where αᵢⱼ is the attention parameter, W is the adjacency weight matrix, ${h}_{j}^{\left(l\right)}$ is the node feature vector, and 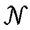 (i) is a neighbor set of the node i.

This multiplication operation combines dynamic attention weights, static graph structure information, and feature information of neighbor nodes, thus finally obtaining a comprehensive "node feature update item". This update item is essentially information obtained through aggregation by a target node from its neighborhood and screening and weighting by the attention mechanism. This result obtained by the activation function processing will be used as an input of the next graph attention layer, or as a final output (e.g., a reconstructed wind speed value) of the last layer of the network.

By performing the above steps 601 and 602, i.e., by accumulating the attention parameters and combining the accumulated attention parameters with the adjacency weight matrix and the node feature vector of the previous graph attention layer, dynamic weighted aggregation of neighborhood information is realized, and a core node feature update item is obtained, so that the network can intelligently pay attention to the most valuable neighbors for reconstruction of information of the missing station; and then by introducing activation function processing, necessary nonlinearity is introduced for the linearly aggregated features, so as to construct a complete node feature update function of the current graph attention layer. As such, the spatio-temporal graph attention network can abstract and refine the complex dependencies in spatio-temporal graph data layer by layer and accurately estimate and impute the wind speed data of the missing stations, thereby improving the quality of data reconstruction.

At step 503, a loss function is constructed based on a data difference between the node feature vector and the station label data.

Step 503 will be described in detail below.

To quantify the performance of the spatio-temporal graph attention network in processing the reconstruction task and guide parameter learning of the spatio-temporal graph attention network, a suitable loss function needs to be defined. In this embodiment, the construction of the loss function is based on a data difference between the node feature vector outputted by the network (especially the wind speed values reconstructed for the missing stations) and real station label data (i.e., original accurate wind speed values of these missing stations), as described below.

Referring to FIG. 7, constructing a loss function based on a data difference between the node feature vector and the station label data includes the following steps 701 to 703.

At step 701, a 2-norm of an edge weight matrix between nodes is multiplied by a regularization coefficient to obtain an edge weight norm.

At step 702, averaging processing is performed on 2-norms of all the data differences to obtain a data difference norm.

At step 703, the edge weight norm and the data difference norm are accumulated to obtain the loss function.

Steps 701 to 703 will be described in detail below.

To prevent overfitting in the training process of the spatio-temporal graph attention network and enable the spatio-temporal graph attention network to learn more concise and generalized parameters, a regularization term is usually included in the loss function. The calculation of this regularization term is based on a 2-norm (Frobenius norm) used in the model to represent the edge weight matrix between nodes. Therefore, the 2-norm of the edge weight matrix between nodes is multiplied by a regularization coefficient λ to obtain an edge weight norm $λ ⋅ {\left‖E\right‖}_{2}^{2}$. The edge weight matrix refers to weight parameters that can be learned in the graph attention layer, which indirectly or directly affect the intensity of information transmission between nodes. The edge weight norm will be used as a penalty term to encourage the model to learn smaller weights, thus preventing the model from becoming too complex.

In addition, the core component of the loss function is a measure to measure the reconstruction accuracy of the model. Therefore, averaging processing is performed on 2-norms of all data differences between the node feature vector outputted by the model (especially the wind speed values reconstructed for the missing stations) and real station label data (i.e., original accurate wind speed values of these missing stations) to obtain a data difference norm, and the edge weight norm and the data difference norm are accumulated to obtain the loss function, as shown in the following formula (10). ${L}_{recon} = \frac{1}{M} {\sum }_{i ∈ M} {\left‖{h}_{i}^{\left(l\right)}-{v}_{i}^{true}\right‖}_{2}^{2} + λ ⋅ {\left‖E\right‖}_{2}^{2}$ (10)

The loss function integrates the fitting goodness of the model to the training data and the complexity control of the model, providing a comprehensive guidance signal for the optimization process of the network. During the training process, a goal of an optimization algorithm (e.g., gradient descent) is to minimize the loss function obtained through accumulation.

By performing the above steps 701 to 703, the edge weight norm is calculated and the regularization coefficient is introduced, so that the risk of model overfitting is effectively suppressed, and the generalization capability of the model is enhanced; the 2-norms of all the data differences are calculated, and averaging processing is performed on the 2-norms to obtain a data difference norm that intuitively reflects the reconstruction performance of the model; then, the edge weight norm and the data difference norm are combined to form a final loss function, thereby enabling the spatio-temporal graph attention network to improve the accuracy of reconstruction of missing wind speed data during training while avoiding learning too complex model parameters. This ensures that the model can have good performance on unseen data, thereby effectively improving the reliability of wind speed data reconstruction in practical applications.

At step 504, a network parameter of the spatio-temporal graph attention network and the node feature vector are iteratively updated based on the node feature update function and the loss function, where the network parameter updated by multiple iterations is used for node relationship attention processing on the continuous spatio-temporal graph sequence.

Step 504 will be described in detail below.

In some embodiments, after the node feature update function and the loss function of the spatio-temporal graph attention network are determined, network parameters of the spatio-temporal graph attention network (parameters related to the calculation of the weight matrix and attention coefficient inside each attention layer) and the node feature vectors that may exist in some architectures are iteratively updated. This iterative update process usually uses gradient descent and its variant algorithm (e.g., Adam optimizer) to adjust network parameters according to a gradient calculated by a back propagation loss function. Details will be given below.

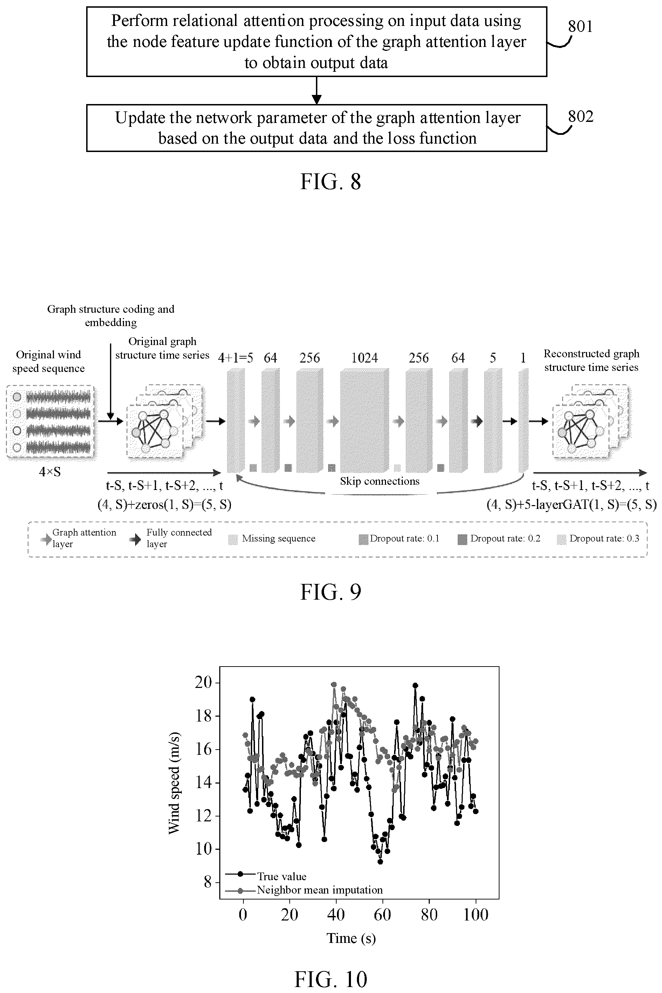

Referring to FIG. 8, iteratively updating a network parameter of the spatio-temporal graph attention network and the node feature vector based on the node feature update function and the loss function includes the following steps 801 to 802.

At step 801, relational attention processing is performed on input data using the node feature update function of the graph attention layer to obtain output data, where input data of the first graph attention layer is the node feature vector, input data of each of graph attention layers other than the first graph attention layer is output data of a graph attention layer previous to the each of graph attention layers, and output data of the last graph attention layer is reconstructed station data of the missing station.

At step 802, the network parameter of the graph attention layer is updated based on the output data and the loss function.

Steps 801 to 802 will be described in detail below.

In some embodiments, a forward propagation stage in the process of iteratively updating the spatio-temporal graph attention network is to use the node feature update function of the graph attention layer to relationship attention processing on input data. The relationship attention processing process is performed layer by layer in a multi-layer cascaded graph attention network: input data of the first graph attention layer is the initial node feature vector (e.g., an original feature of the wind speed station or a feature having been subjected to embedding processing); and input data of each of graph attention layers other than the first graph attention layer is output data of a graph attention layer previous to the each of graph attention layers, so that the information can be propagated layer by layer and continuously refined. Through the node feature update function of each graph attention layer, the node features will be updated according to the corresponding neighborhood information and attention weight. After processing by all the graph attention layers, output data of the last graph attention layer is reconstructed station data of the missing station obtained by the network, which is an estimation of the missing wind speed value by the network under the current parameters.

After obtaining output data (i.e., reconstructed station data) by using each training spatio-temporal graph sequence, the spatio-temporal graph attention network compares the output data with real station label data, and calculates gradients of the loss function with respect to network parameters of the graph attention layer (including hidden layer dimension, dropout rate, learning rate, and other parameters) by using a back propagation algorithm based on the loss function. Then, the network parameters (including hidden layer dimension, dropout rate, learning rate, and other parameters) are updated according to the gradients by using an optimization algorithm (e.g., Adam, SGD, etc.). The goal of this update operation is to adjust the parameters toward a smaller value of the loss function, so that the network can produce an output closer to the true value in the next iteration.

After such iterative update is performed multiple times, the network parameters of the spatio-temporal graph attention network will gradually converge to a set of values that can better complete the reconstruction task. These fully trained network parameters can then be used to implement efficient and accurate node relationship attention processing on a new continuous spatio-temporal graph sequence which is actually observed, to achieve the reconstruction of missing wind speed data in the real world.

The node relationship attention processing is performed in each graph attention layer of the spatio-temporal graph attention network, and its core purpose is to dynamically evaluate and utilize the degree of influence between wind speed stations in the graph to update the feature representation of each node (especially the node whose data is missing) more accurately. During node relationship attention processing performed on the wind speed station data of the missing wind speed station based on the weight adjacency elements through the plurality of graph attention layers cascaded, for each missing wind speed station, an attention coefficient between the missing wind speed station and all other wind speed nodes is calculated in each graph attention layer (as shown in the above formula (8)). Then, the attention coefficient is used as a weight, and weighted aggregation is performed based on weight adjacency elements between the missing wind speed station and other wind speed stations and features of the missing wind speed station and other wind speed stations (the node feature vector from the previous graph attention layer) to realize the feature update of the missing wind speed station in the plurality of graph attention layers (as shown in the above formula (9)). Through the plurality of graph attention layers cascaded, information of the missing wind speed station is propagated and refined layer by layer in the graph, so that the spatio-temporal graph attention network can capture complex long-range and short-range spatio-temporal dependencies, and finally realize the high-precision reconstruction of wind speed station data of the missing wind speed station, thus forming a complete spatio-temporal map sequence.

For example, in this embodiment, an Adam optimizer is selected for model training, the initial learning rate is set to 0.001, a learning rate attenuation strategy is adopted, and the learning rate is multiplied by 0.9 every 50 training cycles. The batch size is set to 64, and the total number of training iterations is set to 10000. An early stopstrategy is adopted during the training process, and the training is ended when the loss of the validation set does not improve for 20 consecutive epoches. Hyperparameter optimization uses a grid search method to determine an optimal combination, including hidden layer dimension, dropout rate, learning rate, and other parameters.

When the trained 5-layer spatio-temporal graph attention network is used to process time-series graph data having missing values, a missing part of a sequence falling within a time window of t-S to t is initialized as zero vector and is passed into the spatio-temporal graph attention network as an input. The spatio-temporal graph attention network captures a spatial relationship between nodes and time-series features of each node through a multi-layer graph attention mechanism, finally outputs a reconstructed complete graph structure sequence, and obtains a complete spatio-temporal graph sequence based on graph structure sequences corresponding to a plurality of consecutive moments. The reconstruction process is expressed as: (4,S)+zeros(1,S)-(5,5)-(4,5)+5-layerGAT(1,S)-(5,S), where S represents the number of stations, 4 represents the number of historical time steps retained by each station, 1 represents the number of time steps that need to be reconstructed, and 5 represents the total number of time steps outputted (including historical and predicted time steps).

FIG. 9 is a schematic diagram of a structural framework of a spatio-temporal graph attention reconstruction model according to an embodiment of the present disclosure. As shown in FIG. 9, an original wind speed series including missing station data and a corresponding original graph structure time series are used as an input. The data then enter a network formed by a plurality of graph attention layers and a fully connected layer cascaded. FIG. 9 also shows processing of missing sequences and different dropout rates used to prevent overfitting. A skip connections operation that exists in the network facilitate information flow and feature learning. Through processing by these layers, especially the node relationship attention processing by the graph attention layers, the network finally outputs a reconstructed graph structure time series, i.e., a complete spatio-temporal graph sequence obtained by completing the wind speed station data of the missing wind speed station.

To further reflect the reliability of data reconstruction provided in the present disclosure, the quality of reconstructed data is evaluated according to a plurality of indicators in this embodiment. The plurality of indicators include: mean absolute error (MAE), mean square error (MSE), mean absolute percentage error (MAPE), and reconstruction accuracy, respectively expressed as formulas (11) to (13) below. $MAE = \frac{1}{N} {\sum }_{i = 1}^{N} \left(\frac{1}{Q}{\sum }_{j = 1}^{Q} \left|{Y}_{j}^{i}-\hat{{Y}_{j}^{ι}}\right|\right)$ (11) $MSE = \frac{1}{N} {\sum }_{i = 1}^{N} \left(\frac{1}{Q}{\sum }_{j = 1}^{Q} {\left|{Y}_{j}^{i}-\hat{{Y}_{j}^{ι}}\right|}^{2}\right)$ (12) $MAPE = \frac{1}{N} {\sum }_{i = 1}^{N} \left(\frac{1}{Q}{\sum }_{j = 1}^{Q} \frac{\left|{Y}_{j}^{i}-\hat{{Y}_{j}^{ι}}\right|}{{Y}_{j}^{i}}\right) \times 100 %$ (13) where $\hat{{Y}_{j}^{ι}}$ and ${Y}_{j}^{i}$ are respectively a predicted wind speed value and a ground true value of a station i at a moment j; Q is the length of the predicted time series; and N is the number of stations.

Using the trained spatio-temporal graph attention network, other complete node sequences are used as a model input, to obtain a corresponding wind speed sequence output of the missing station, which is compared with real data. Simulation and comparison of models respectively using five baseline sequence imputation strategies (neighbor mean imputation strategy, feature propagation imputation strategy, random imputation strategy, mean imputation strategy, and 5-layer graph convolution imputation strategy) are described below.

FIG. 10 is a schematic diagram of performance simulation of a first spatio-temporal graph attention reconstruction model according to an embodiment of the present disclosure. FIG. 10 shows the performance of the "neighbor mean imputation" method in reconstructing missing wind speed data. In the figure, the black curve represents the "true value" of wind speed over time, and the red curve represents a result of "neighbor mean imputation" using the mean wind speed of neighbor stations to impute missing data. It can be seen from FIG. 10 that although "neighbor mean imputation" can roughly follow the trend of true values in some gently changing areas, there is a significant deviation between the reconstruction results and the true values in areas with large wind speed fluctuations or with peak/valley values, making it difficult to accurately capture the dynamic characteristics of wind speed. This reflects the limitations of conventional spatial interpolation methods in dealing with missing of complex wind speed data.

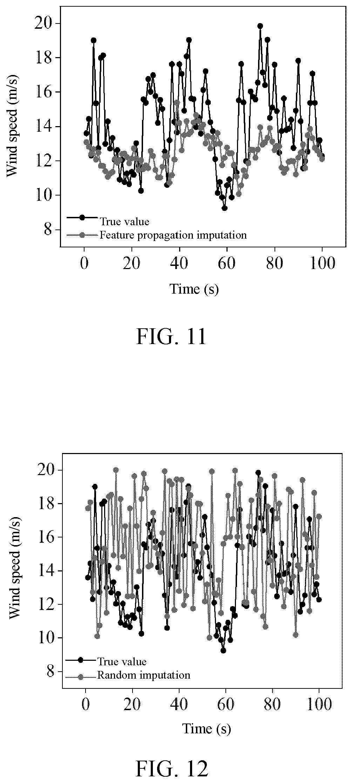

FIG. 11 is a schematic diagram of performance simulation of a second spatio-temporal graph attention reconstruction model according to an embodiment of the present disclosure. FIG. 11 shows an effect of wind speed data reconstruction using the "feature propagation imputation" method. In the figure, the black curve represents the "true value" of wind speed, and the red curve is a result of imputing missing data through feature propagation. Compared with "neighbor mean imputation," "feature propagation imputation" may consider the correlation between nodes to a certain extent, but the wind speed curve reconstructed by "feature propagation imputation" is still significantly different from true values at multiple time points, especially in areas where the wind speed changes rapidly and areas where extreme values appear. This indicates that the ability of "feature propagation imputation" to capture complex spatio-temporal dependencies and accurately reconstruct missing data is limited.

FIG. 12 is a schematic diagram of performance simulation of a third spatio-temporal graph attention reconstruction model according to an embodiment of the present disclosure. FIG. 12 shows the performance of the "random imputation" method in reconstructing missing wind speed data. In the figure, the black curve represents the "true value" of wind speed, and the red curve represents a result of "random imputation" using a random numerical value to impute missing data. FIG. 12 shows that there is almost no correlation between the results of "random imputation" and the real wind speed, and the reconstructed wind speed curve shows a high degree of disorder and inaccuracy.

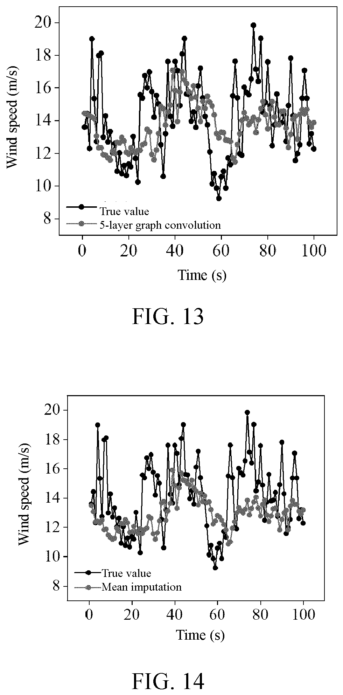

FIG. 13 is a schematic diagram of performance simulation of a fourth spatio-temporal graph attention reconstruction model according to an embodiment of the present disclosure. FIG. 13 shows the performance of a "5-layer graph convolution" network in reconstructing missing wind speed data. In the figure, the black curve represents the "true value" of wind speed, and the red curve represents a reconstructed wind speed obtained through processing by the 5-layer graph convolution network. The graph convolution network can use graph structure information for feature learning, and therefore achieves a significantly improved reconstruction result compared with the above simple imputation methods, and can better follow the fluctuation trend of the real wind speed.

FIG. 14 is a schematic diagram of performance simulation of a fifth spatio-temporal graph attention reconstruction model according to an embodiment of the present disclosure. FIG. 14 shows the performance of the "mean imputation" method (using the mean of the entire sequence or the mean of a specific time window) in reconstructing missing wind speed data. In the figure, the black curve represents the "true value" of wind speed, and the red curve represents a result of the "mean imputation". The reconstructed wind speed curve obtained by this method is usually too smooth to reflect the dynamic changes and detailed characteristics of the real wind speed, and is quite different from the real value especially in time periods when the wind speed fluctuates violently.

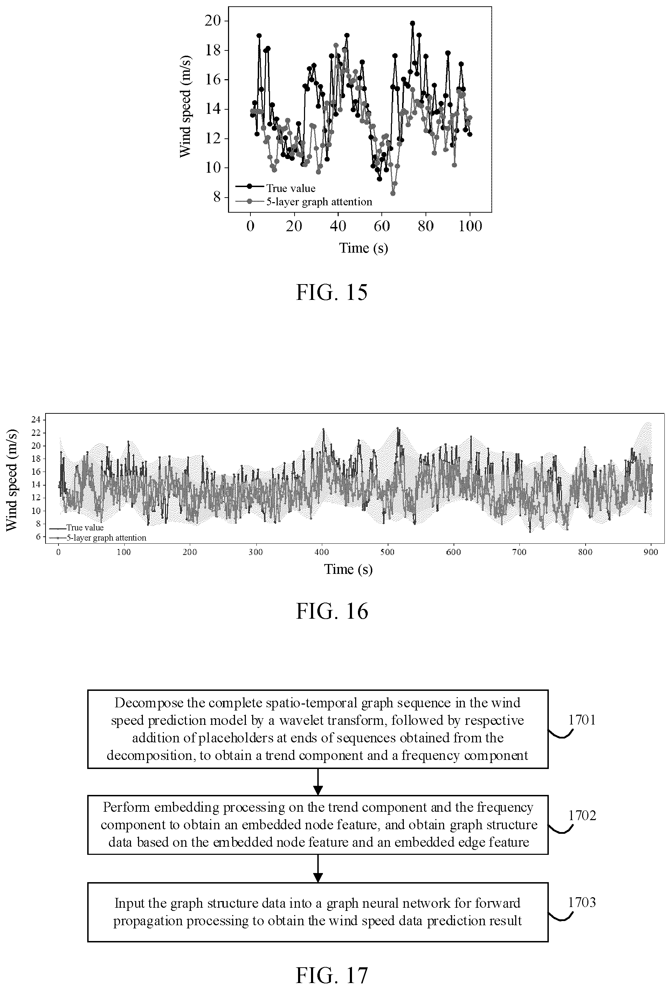

FIG. 15 is a schematic diagram of performance simulation of a sixth spatio-temporal graph attention reconstruction model according to an embodiment of the present disclosure. FIG. 15 shows the performance of a spatio-temporal graph attention reconstruction network provided in the present disclosure in reconstructing missing wind speed data. In the figure, the black curve represents the "true value" of wind speed, and the red curve represents a wind speed reconstructed by the 5-layer graph attention network. It can be clearly seen that the red curve is highly consistent with the black curve, and can capture various fluctuations, peaks, and valleys of real wind speed very accurately, so this method is significantly superior to other comparison methods. This proves that the spatio-temporal graph attention network provided in the present disclosure can effectively learn and utilize the complex dynamic spatio-temporal dependencies between measurement stations in the wind speed field through node relationship attention processing, to realize high-precision reconstruction of missing wind speed station data, thereby providing a high-quality complete spatio-temporal graph sequence for subsequent wind speed data prediction.

FIG. 16 is a schematic diagram of performance simulation of a seventh spatio-temporal graph attention reconstruction model according to an embodiment of the present disclosure. FIG. 16 shows the performance of the spatio-temporal graph attention reconstruction network provided in the present disclosure in reconstructing wind speed data over a longer time span (about 900 seconds). In the figure, the black curve represents the "true value" of wind speed, the red curve represents the reconstruction result of the model, and shaded areas around the two curves may indicate uncertainty or an error range. It can be seen from the figure that even in a long time series, the red curve can still closely follow the complex changes of the black curve, including long-term trends and short-term violent fluctuations, and the uncertainty ranges of the two curves also show good consistency. This demonstrates the robustness and high accuracy of the spatio-temporal graph attention reconstruction network provided in the present disclosure when processing actual continuous wind speed data, and the spatio-temporal graph attention reconstruction network can continuously and stably generate high-quality complete spatio-temporal graph sequences.

Through the training process including the above steps 501 to 504, the network parameters of the network can capture complex spatio-temporal dependencies, and use these dependencies to accurately infer missing data, so that the trained spatio-temporal graph attention network can perform high-quality node relationship attention processing on the continuous spatio-temporal graph sequence including a missing wind speed station, to generate a complete spatio-temporal graph sequence including accurately reconstructed data, thereby providing a more reliable and complete data basis for subsequent wind speed prediction or other analysis tasks.

At step 103, the complete spatio-temporal graph sequence is inputted into a wind speed prediction model for data processing to obtain a wind speed data prediction result of the prediction scenario.

Step 103 will be described in detail below.

In some embodiments, because the complete spatio-temporal graph sequence, which is obtained through data reconstruction in the prediction scenario, already includes wind speed information of all wind speed stations in the prediction scenario (including the wind speed station whose data was previously missing) and retains rich spatio-temporal structure characteristics, the complete spatio-temporal graph sequence is fed into a pre-constructed wind speed prediction model for further data processing (including feature extraction, pattern learning and time series evolution inference, and other complex operations) to output a wind speed data prediction result of the prediction scenario, i.e., to output an accurate estimation of wind speed values of wind speed stations in one or more time steps in the future.

To enable the wind speed prediction model to accurately predict wind speed data of the prediction scenario, in this embodiment, a graph neural network (GNN) and a time-series transformer are combined to construct a hybrid model as a wind speed prediction model for wind speed sequence prediction, the data residual is used as the loss function of the neural network to train parameters of the neural network, and the trained neural network can be used to predict distributed wind speeds.

In the wind speed prediction model, three embedding layers, i.e., a frequency component embedding layer, a trend component embedding layer, and an edge feature embedding layer, are designed to respectively deal with the embedding transformation of a frequency component, a trend component, and an edge feature. The frequency component embedding layer maps the frequency component obtained through decomposition to a hidden dimensional space of the model. The trend component embedding layer maps a main trend component of the time series to a hidden dimensional space of the model. The edge feature embedding layer maps an edge feature describing a relationship between nodes to a hidden dimensional space of the model.

The wind speed prediction model includes a plurality of layers each layer including an edge update function and a node update function. The edge update function is a standard transformer encoder layer, which includes therein a full attention mechanism responsible for updating edge features. The node update function is a standard transformer encoder layer, which integrates a probabilistic fast Fourier transform attention mechanism and a logarithmic sparse attention mode to improve the efficiency of long sequence processing.

In the wind speed prediction model, a wavelet transform decomposition module is defined and predicted placeholders are added.

In the wind speed prediction model, an Adam optimizer is selected for model training, and a cosine annealing learning rate scheduling strategy is used. The loss function is a mean square error (MSE).

In the process of training the wind speed prediction model, the reconstructed complete spatio-temporal graph sequence structure is divided into training datasets according to designed prediction windows. Three types of prediction windows are designed: predicting 1 step size according to 30 labeled step sizes, predicting 10 step sizes according to 30 labeled step sizes, and predicting 30 step sizes according to 60 labeled step sizes. The dataset is divided into three parts: 60% for training, 20% for validation, and 20% for testing. Then, the input sequence is decomposed by wavelet transform so that the original time series is decomposed into a trend component and a frequency component, and placeholders are respectively added at ends of sequences obtained from the decomposition. Afterward, the prepared trend component, frequency component, and edge feature are respectively processed through the corresponding embedding layers, and then the embedded node feature and edge feature are reorganized into a graph structure, to be inputted into the graph neural network. Then, the processed graph structure data is inputted into the graph neural network for forward propagation, to generate a complete predicted sequence and an attention weight. According to a prediction length, a corresponding prediction result is extracted, with output dimensions being [batch size, prediction length, feature dimension], to represent a predicted wind speed value of a time step in the future.

Each training process includes calculating predicted values and losses through forward propagation, calculating gradients through back propagation, updating model parameters using an optimizer, evaluating model performance with a validation set, adjusting the learning rate according to performance of the validation set, and checking an early stop condition. After the training is completed, the model can receive wind speed data of an arbitrary graph structure as an input to predict a wind speed value of a time step in the future.

Based on the wind speed prediction model constructed above, how to use the wind speed prediction model to predict wind speed data will be further described below.

Referring to FIG. 17, inputting the complete spatio-temporal graph sequence into a wind speed prediction model for data processing to obtain a wind speed data prediction result of the prediction scenario includes the following steps 1701 to 1703.

At step 1701, the complete spatio-temporal graph sequence is decomposed in the wind speed prediction model by a wavelet transform, followed by respective addition of placeholders at ends of sequences obtained from the decomposition, to obtain a trend component and a frequency component.

At step 1702, embedding processing is performed on the trend component and the frequency component to obtain an embedded node feature, and graph structure data is obtained based on the embedded node feature and an embedded edge feature.

At step 1703, the graph structure data is inputted into a graph neural network for forward propagation processing to obtain the wind speed data prediction result.

Steps 1701 to 1703 will be described in detail below.

In some embodiments, when the complete spatio-temporal graph sequence is inputted into the wind speed prediction model for data processing, the wind speed prediction model first preprocesses time series data in the complete spatio-temporal graph sequence, i.e., decomposes wind speed time series data in the complete spatio-temporal graph sequence by a wavelet transform. It can be understood that wavelet transform is a powerful signal analysis tool capable of decomposing a time series into different time-frequency domains, thus effectively separating different components of the signal. After this decomposition process, placeholders are respectively added at ends of sequences obtained from the decomposition, to facilitate the subsequent unified processing or sequence alignment by the model. Through this series of operations, the original wind speed time series data is decomposed into a trend component (representing long-term changes and low-frequency characteristics of the signal) and a frequency component (representing short-term fluctuations and high-frequency details of the signal) that are easier to learn by the model.

After the trend component and the frequency component are obtained, embedding processing is respectively performed on the trend component and the frequency component (i.e., a component of a numerical type or class type (if applicable) is mapped into a high-dimensional, dense vector space), to obtain embedded node features including richer semantic information. These embedded node features represent the dynamic characteristics of each wind speed station at different time scales. In addition, the model also combines a connection relationship of graphs with attributes of edges, i.e., embedded edge features (which may be from edge features in the original graph construction stage, and are also subjected to embedding processing to match the dimensions and representation mode of node features), and combine the embedded node features with the topology of the graph to obtain graph structure data. This graph structure data not only includes dynamic characteristics of nodes, but also includes spatial association information between nodes.

After the graph structure data is obtained, the graph structure data is inputted into a graph neural network (GNN), and information propagation and aggregation are performed among the nodes of the graph through a message passing mechanism for forward propagation processing, i.e., the data flows through each layer of the GNN, and each layer updates a representation of a node according to information of neighbor nodes and features of the node. Through the information aggregation and transformation by the layers, the GNN can learn complex spatio-temporal dependencies and patterns, and finally output a prediction of future wind speed, i.e., obtain a wind speed data prediction result.

By performing the above steps 1701 to 1703, the complete spatio-temporal graph sequence is decomposed by a wavelet transform to enable the model to respectively pay attention to trend and fluctuation details in the wind speed data, followed by addition of placeholders; then, the components obtained through decomposition and edge information are transformed into high-dimensional features by embedding processing; graph structure data including rich spatio-temporal information is constructed; and a powerful graph learning ability of the graph neural network is used to deeply process the graph structure data, so as to capture complex spatio-temporal dynamics and generate an accurate wind speed data prediction result. As such, the model can understand the evolution law of wind speed more comprehensively, and finally realize high-precision prediction of wind speed data in the prediction scenario.

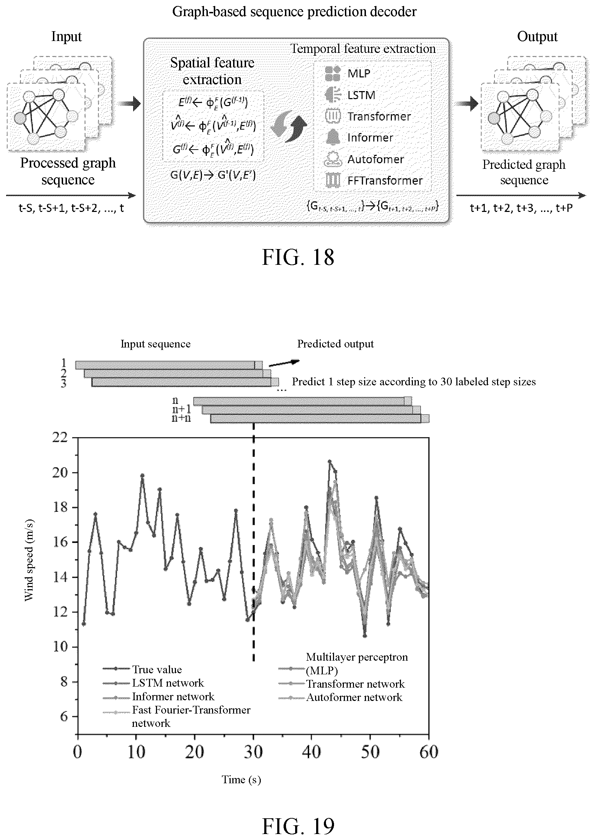

FIG. 18 is a schematic diagram of a structural framework of a wind speed prediction model based on a spatio-temporal graph sequence according to an embodiment of the present disclosure. As shown in FIG. 18, a "processed graph sequence" (i.e., complete spatio-temporal graph sequence) is used as an input of the model. The model includes two core modules: a spatial feature extraction module and a temporal feature extraction module, which work collaboratively. The model can capture both complex spatial dependencies and temporal dynamics, and finally output a predicted graph sequence, i.e., a wind speed data prediction result of the prediction scenario.

To further reflect the reliability and accuracy of the data prediction provided in the present disclosure, a trained wind speed prediction model is validated by comparing data measured by a validation measurement point with a predicted value of the model, and the prediction accuracy of the model in different prediction windows is evaluated through comparison of baseline models. Original wind speed data of a test set is used as an input of the model, to obtain an output of a corresponding prediction window step size. Simulation and comparison between outputs of different sequence prediction models and real values, and the predictability of reconstructed data are shown below.

FIG. 19 is a schematic diagram of performance simulation of a first wind speed prediction model based on a spatio-temporal graph sequence according to an embodiment of the present disclosure. FIG. 19 shows the performance of the wind speed prediction model when performing wind speed prediction for 1 labeled step size in the future using a complete spatio-temporal graph sequence of 30 labeled step sizes as an input. In the figure, the black curve represents the "true value" of wind speed, and curves in other colors respectively represent predicted outputs of different prediction models (e.g., LSTM, MLP, Transformer, Informer, Autoformer, and a fast Fourier-Transformer network used in this scheme, i.e., wind speed prediction model). It can be seen that for short-term single-step prediction, a plurality of advanced models, especially the wind speed prediction model corresponding to the Transformer architecture provided in this scheme, can better track the changing trend of real wind speed, which indicates that the strategy of inputting a complete spatio-temporal graph sequence into the wind speed prediction model for processing to obtain a wind speed data prediction result in the present disclosure can achieve a good prediction effect for short-term prediction.

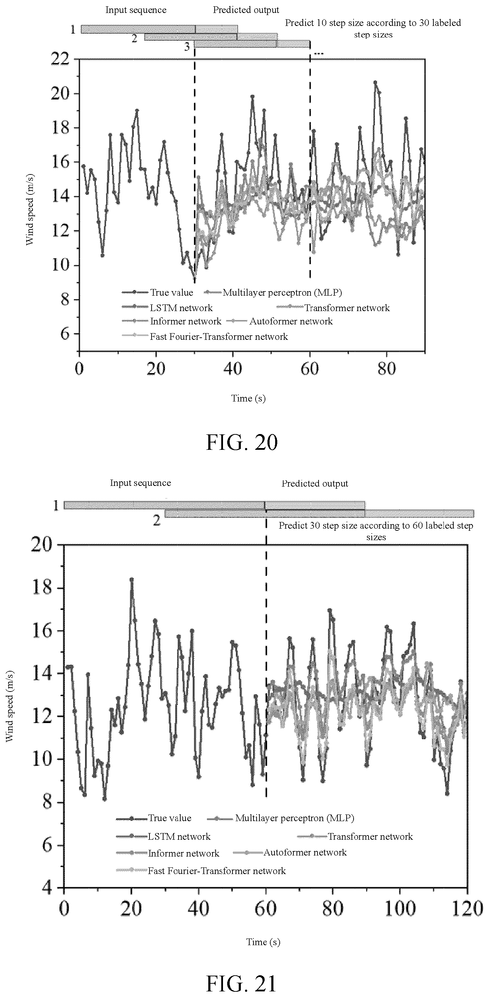

FIG. 20 is a schematic diagram of performance simulation of a second wind speed prediction model based on a spatio-temporal graph sequence according to an embodiment of the present disclosure. As shown in FIG. 20, a prediction horizon is extended to 10 labeled step sizes in the future. When the prediction step size increases, the differences between the prediction performance of different models become more significant. The figure shows that although the prediction accuracy of all models has decreased compared to single-step prediction, advanced transformer-based models (e.g., Transformer, Informer, Autoformer, and fast Fourier-Transformer network) can capture the main fluctuation characteristics and trends of wind speed more accurately than LSTM and MLP, and have better performance than LSTM and MLP especially in predicting peaks and valleys. This shows that the wind speed prediction model provided in the present disclosure can effectively utilize spatio-temporal information in a complete spatio-temporal graph sequence when processing a medium-length multi-step prediction task, and provide a reliable wind speed data prediction result.

FIG. 21 is a schematic diagram of performance simulation of a third wind speed prediction model based on a spatio-temporal graph sequence according to an embodiment of the present disclosure. FIG. 21 shows the performance of the wind speed prediction model under the conditions of a longer input sequence (60 labeled step sizes) and a longer prediction horizon (30 labeled step sizes). As the prediction time increases significantly, the prediction difficulty increases significantly, and the prediction errors of all models increase. However, it can still be seen from the figure that advanced models such as Autoformer and fast Fourier-Transformer network (i.e., the wind speed prediction model provided in the present disclosure) show stronger robustness for long-term prediction, and prediction curves of the advanced models can still maintain a certain degree of consistency with true values in terms of the overall trend and some key fluctuations. This shows that when dealing with a challenging long-term wind speed prediction task, the wind speed prediction model provided in the present disclosure can still implement deep learning of spatio-temporal features of a complete spatio-temporal graph sequence, to extract effective information and generate an accurate wind speed data prediction result.

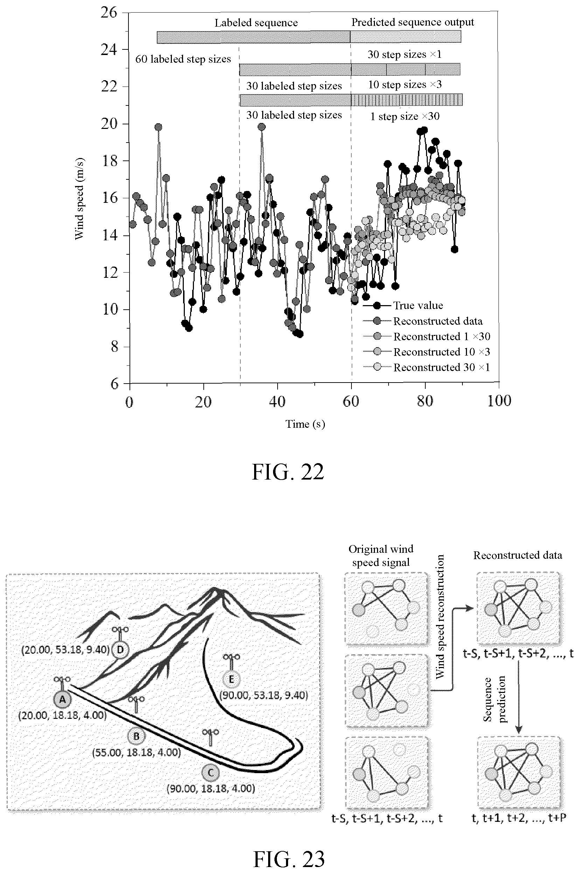

FIG. 22 is a schematic diagram of performance simulation of a fourth wind speed prediction model based on a spatio-temporal graph sequence according to an embodiment of the present disclosure. FIG. 22 shows the association between data reconstruction and subsequent prediction in the scheme provided in the present disclosure and the effects of different prediction strategies. In the figure, the blue curve (reconstructed data) and the black curve (true value) of "Labeled sequence" are highly consistent in the historical data part, which shows the efficiency and accuracy of data reconstruction by the spatio-temporal graph attention network. Based on the high-quality reconstructed data (i.e., complete spatio-temporal graph sequence), the "Predicted sequence output" part compares wind data prediction results obtained by a plurality of prediction strategies (e.g., predicting 30 step sizes at a time, predicting 10 steps for 3 times, and predicting 1 step for 30 times). It can be seen that different prediction strategies have an impact on the final prediction accuracy, provided that the prediction relies on high-quality reconstructed data obtained in the early stage. This proves the overall effectiveness of the technical route of accurate reconstruction followed by prediction in the present disclosure, and proves that a high-quality complete spatio-temporal graph sequence is a key basis for achieving an accurate wind speed data prediction result.

FIG. 23 is a schematic flowchart of wind speed data prediction in a prediction scenario according to an embodiment of the present disclosure. FIG. 23 shows a schematic diagram of a comprehensive application scenario, which intuitively demonstrates a complete implementation process and an expected result of the wind speed data prediction method provided in the present disclosure in a specific prediction scenario (e.g., a mountainous environment along railways, including stations A, B, C, D, E and their three-dimensional coordinates). The left part of the figure shows the distribution of original wind speed signals of multiple wind speed stations in a specific geographical environment, and a graph structure time series formed by the original wind speed signals in the time dimension, where there is missing data (as shown by a light-colored node). The middle part of the figure shows a wind speed reconstruction process for converting an original signal sequence including missing data into a reconstructed data time series with complete data (i.e., complete spatio-temporal graph sequence). Then, the reconstructed data is inputted for sequence prediction, to finally obtain a wind speed data prediction result of a time period in the future (t+1, t+2, ..., t+P).

Embodiments of the present disclosure provide a wind speed data prediction method and apparatus, an electronic device, and a storage medium. The method includes the following steps. First, three-dimensional spatial coordinates of a plurality of wind speed stations in a prediction scenario are acquired; a weighted summation operation is performed based on the three-dimensional spatial coordinates and directional weights of every two of the wind speed stations to obtain edge features between every two of the wind speed stations; percentage processing is performed on differences between the three-dimensional spatial coordinates of every two of the wind speed stations to obtain graph connection thresholds; when the differences between the three-dimensional spatial coordinates of every two of the wind speed stations respectively do not exceed the graph connection thresholds, the weight adjacency elements of every two of the wind speed stations are obtained based on reciprocals of the edge features, and all of the weight adjacency elements are combined to obtain an adjacency matrix; a degree matrix is obtained based on a sum of elements of each column in the adjacency matrix; normalization processing is performed based on the degree matrix to obtain a graph structure; and graph structures corresponding to a plurality of consecutive moments are combined to obtain a continuous spatio-temporal graph sequence, where the continuous spatio-temporal graph sequence includes an adjacency matrix, the continuous spatio-temporal graph sequence does not include wind speed station data of a missing wind speed station, and the adjacency matrix includes weight adjacency elements between the missing wind speed station and other wind speed stations. Then, the continuous spatio-temporal graph sequence is inputted into a spatio-temporal graph attention network, and node relationship attention processing is sequentially performed on the wind speed station data of the missing wind speed station based on the weight adjacency elements through a plurality of graph attention layers cascaded to obtain a complete spatio-temporal graph sequence, where the complete spatio-temporal graph sequence includes the wind speed station data of the missing wind speed station. A process of training the spatio-temporal graph attention network includes: acquiring a plurality of training spatio-temporal graph sequences, where each of the training spatio-temporal graph sequences includes data of a plurality of stations, missing station data, an adjacency weight matrix between a missing station and other stations, and station label data corresponding to the missing station data; generating a node feature vector based on the missing station data; calculating a sum of the attention parameter between the missing station and each other station, and multiplying the sum by the adjacency weight matrix and the node feature vector of a previous graph attention layer to obtain a node feature update term; performing activation function processing based on the node feature update item to obtain the node feature update function of the current graph attention layer; multiplying a 2-norm of an edge weight matrix between nodes by a regularization coefficient to obtain an edge weight norm; performing averaging processing on 2-norms of all the data differences to obtain a data difference norm; accumulating the edge weight norm and the data difference norm to obtain the loss function; and iteratively updating a network parameter of the spatio-temporal graph attention network and the node feature vector based on the node feature update function and the loss function, where the network parameter updated by multiple iterations is used for node relationship attention processing on the continuous spatio-temporal graph sequence. Finally, the complete spatio-temporal graph sequence is decomposed in the wind speed prediction model by a wavelet transform, followed by respective addition of placeholders at ends of sequences obtained from the decomposition, to obtain a trend component and a frequency component; embedding processing is performed on the trend component and the frequency component to obtain an embedded node feature, and obtaining graph structure data based on the embedded node feature and an embedded edge feature; and the graph structure data is inputted into a graph neural network for forward propagation processing to obtain the wind speed data prediction result.

In the embodiments of the present disclosure, a spatial topological relationship between wind speed stations and potential influence intensity of each wind speed station can be determined from the initial stage by constructing a continuous spatio-temporal graph sequence including weight adjacency elements, thereby laying a structuring foundation for subsequent processing. Then, a spatio-temporal graph attention network is used to process a sequence including missing data, and wind speed data of a missing station can be reconstructed with high precision by intelligently and dynamically learning and utilizing data of known stations and a spatio-temporal correlation between the known stations by means of a node relationship attention mechanism of a plurality of graph attention layers. This scheme is far superior to a conventional spatial interpolation method that only relies on a fixed spatial distance or statistical characteristic, and can obtain a more realistic and complete spatio-temporal graph sequence. Afterward, the high-quality complete spatio-temporal graph sequence is inputted into a subsequent wind speed prediction model, so that the prediction model can learn and infer based on more comprehensive and accurate spatio-temporal dependency information, thereby overcoming the deficiencies of the existing technology in processing missing data and capturing a complex dynamic spatio-temporal dependency, and significantly improving the accuracy of wind speed data prediction in complex prediction scenarios (e.g., a railway environment). In addition, the weight adjacency elements in the adjacent matrix are accurately defined through threshold-based judgment and calculation of reciprocals of the edge features, to reflect the connection strength between stations; then, the degree matrix is calculated, and normalization processing is performed based on the degree matrix to obtain a normalized graph structure, which facilitates subsequent model processing; graph structures corresponding to a plurality of time points are organically combined to form a continuous spatio-temporal sequence which can comprehensively describe the spatio-temporal dynamic characteristics of the wind speed field. This ensures that the inputted spatio-temporal graph sequence can accurately capture complex spatial dependencies and the evolution of the complex spatial dependencies with time, providing a solid data basis for subsequent missing data reconstruction and high-precision wind speed prediction. Moreover, the spatial relationship between stations is more finely described by using the edge features calculated by introducing directional weights, and the graph connection thresholds are adaptively determined by performing percentage processing on the differences between the three-dimensional spatial coordinates, which makes the graph construction more robust; and then these information is comprehensively used to generate a continuous spatio-temporal graph sequence that can reflect the dynamic characteristics of the real wind speed field, which can more accurately capture the complex interaction between measurement stations in the wind speed field, and provides a solid foundation for subsequent high-precision data reconstruction and prediction, thereby improving the effectiveness and reliability of the entire prediction scheme. Furthermore, by accumulating the attention parameters and combining the accumulated attention parameters with the adjacency weight matrix and the node feature vector of the previous graph attention layer, dynamic weighted aggregation of neighborhood information is realized, and a core node feature update item is obtained, so that the network can intelligently pay attention to the most valuable neighbors for reconstruction of information of the missing station; and then by introducing activation function processing, necessary nonlinearity is introduced for the linearly aggregated features, so as to construct a complete node feature update function of the current graph attention layer. As such, the spatio-temporal graph attention network can abstract and refine the complex dependencies in spatio-temporal graph data layer by layer and accurately estimate and impute the wind speed data of the missing stations, thereby improving the quality of data reconstruction. In addition, the edge weight norm is calculated and the regularization coefficient is introduced, so that the risk of model overfitting is effectively suppressed, and the generalization capability of the model is enhanced; the 2-norms of all the data differences are calculated, and averaging processing is performed on the 2-norms to obtain a data difference norm that intuitively reflects the reconstruction performance of the model; then, the edge weight norm and the data difference norm are combined to form a final loss function, thereby enabling the spatio-temporal graph attention network to improve the accuracy of reconstruction of missing wind speed data during training while avoiding learning too complex model parameters. This ensures that the model can have good performance on unseen data, thereby effectively improving the reliability of wind speed data reconstruction in practical applications. Moreover, the complete spatio-temporal graph sequence is decomposed by a wavelet transform to enable the model to respectively pay attention to trend and fluctuation details in the wind speed data, followed by addition of placeholders; then, the components obtained through decomposition and edge information are transformed into high-dimensional features by embedding processing; graph structure data including rich spatio-temporal information is constructed; and a powerful graph learning ability of the graph neural network is used to deeply process the graph structure data, so as to capture complex spatio-temporal dynamics and generate an accurate wind speed data prediction result. As such, the model can understand the evolution law of wind speed more comprehensively, and finally realize high-precision prediction of wind speed data in the prediction scenario.

An embodiment of the present disclosure provides an electronic device, including:
at least one memory;
at least one processor; and
at least one program,
where the at least one program is stored in the at least one memory, and the at least one processor is configured for executing the at least one program to implement the wind speed data prediction method of the present disclosure. The electronic device may be any intelligent terminal including a mobile phone, a tablet computer, a personal digital assistant (PDA), a vehicle-mounted computer, etc.

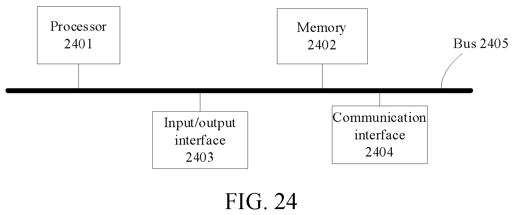

FIG. 24 shows a hardware structure of an electronic device according to another embodiment. Referring to FIG. 24, the electronic device includes a processor 2401, a memory 2402, an input/output interface 2403, a communication interface 2404, and a bus 2405.

The processor 2401 may be implemented by a general-purpose Central Processing Unit (CPU), a microprocessor, an Application Specific Integrated Circuit (ASIC), or one or more integrated circuits, and is configured for executing a related program to implement the technical schemes provided by the embodiments of the present disclosure.

The memory 2402 may be implemented in the form of a Read Only Memory (ROM), a static storage device, a dynamic storage device, a Random Access Memory (RAM), etc. The memory 2402 may store an operating system and other application programs. When the technical schemes provided by the embodiments of the present disclosure are implemented by software or firmware, related program code is stored in the memory 2402, and is called by the processor 2401 to execute the wind speed data prediction method according to the embodiments of the present disclosure.

The input/output interface 2403 is configured for enabling input and output of information.

The communication interface 2404 is configured for realizing communication interaction between the electronic device and other devices, either through wired communication (e.g., USB, network cable, etc.) or through wireless communication (e.g., mobile network, Wi-Fi, Bluetooth, etc.).

The bus 2405 is configured for transmitting information between components of the electronic device (such as the processor 2401, the memory 2402, the input/output interface 2403, and the communication interface 2404).

The processor 2401, the memory 2402, the input/output interface 2403, and the communication interface 2404 are in communication connection with each other inside the electronic device through the bus 2405.

An embodiment of the present disclosure provides a storage medium, which is computer-readable storage medium and stores a computer program which, when executed by a processor, causes the processor to implement the wind speed data prediction method described above.

The memory, as a non-transitory computer-readable storage medium, may be configured for storing a non-transitory software program and a non-transitory computer-executable program. In addition, the memory may include a high-speed random access memory, and may also include a non-transitory memory, e.g., at least one magnetic disk storage device, flash memory device, or other non-transitory solid-state storage device. In some implementations, the memory may include memories located remotely from the processor, and the remote memories may be connected to the processor via a network. Examples of the network include, but are not limited to, the Internet, an intranet, a local area network, a mobile communication network, and combinations thereof.

The contents described in the embodiments of the present disclosure are for the purpose of illustrating the technical schemes of the embodiments of the present disclosure more clearly, and do not constitute a limitation on the technical schemes provided in the embodiments of the present disclosure. Those having ordinary skills in the art may know that with the evolution of technologies and the emergence of new application scenarios, the technical schemes provided in the embodiments of the present disclosure are also applicable to similar technical problems.

Those having ordinary skills in the art may understand that the technical scheme shown in the drawings does not constitute a limitation to the embodiments of the present disclosure, and more or fewer steps than those shown in the figure may be included, or some steps may be combined, or different steps may be used.

The apparatus embodiments described above are merely examples. The units described as separate components may or may not be physically separated, i.e., may be located in one place or may be distributed over a plurality of network units. Some or all of the modules may be selected according to actual needs to achieve the objects of the scheme of this embodiment.

Those having ordinary skills in the art can understand that all or some of the steps in the methods disclosed above and the functional modules/units in the system and the apparatus can be implemented as software, firmware, hardware, and appropriate combinations thereof.

In the specification and accompanying drawings of the present disclosure, the terms "first," "second," "third," "fourth," and so on (if any) are intended to distinguish between similar objects but do not necessarily indicate a specific order or sequence. It is to be understood that the data termed in such a way are interchangeable in appropriate circumstances, so that the embodiments of the present disclosure described herein can be implemented in orders other than the order illustrated or described herein. Moreover, the terms "include," "comprise," and any other variants thereof mean are intended to cover a non-exclusive inclusion. For example, a process, method, system, product, or device that includes a list of steps or units is not necessarily limited to those expressly listed steps or units, but may include other steps or units not expressly listed or inherent to such a process, method, product, or device.

It is to be understood that in the present disclosure, "at least one" means one or more and "a plurality of" means two or more. The term "and/or" is used for describing an association between associated objects and representing that three associations may exist. For example, "A and/or B" may indicate that only A exists, only B exists, and both A and B exist, where A and B may be singular or plural. The character "/" generally indicates an "or" relationship between the associated objects. "At least one of' and similar expressions refer to any combination of items listed, including one item or any combination of a plurality of items. For example, at least one of a, b, or c may represent a, b, c, "a and b," "a and c," "b and c," or "a, b, and c," where a, b, and c may be singular or plural.

In the several embodiments provided in the present disclosure, it is to be understood that the disclosed apparatus and method may be implemented in other manners. For example, the described apparatus embodiments are only exemplary. For example, the division of the units is merely a logical function division and other division manners may be used in practical implementations. For example, a plurality of units or components may be combined or integrated into another system, or some features may be ignored or not performed. The shown or discussed mutual couplings or direct couplings or communication connections may be implemented through some interfaces. The indirect couplings or communication connections between the apparatus or units may be implemented in electronic, mechanical, or other forms.

The units described as separate parts may or may not be physically separate. Parts displayed as units may or may not be physical units, and may be located in one place, or may be distributed on a plurality of network units. Some or all of the units may be selected according to actual needs to achieve the objects of the scheme of this embodiment.

In addition, functional units in the embodiments of the present disclosure may be integrated into one processing unit, or each of the units may exist alone physically, or two or more units may be integrated into one unit. The integrated unit may be implemented in the form of hardware, or may be implemented in the form of a software functional unit.

The integrated unit may be stored in a computer-readable storage medium if implemented in the form of a software functional unit and sold or used as an independent product. Based on such an understanding, the technical schemes of the present disclosure essentially, or the part contributing to the related art, or all or some of the technical schemes may be implemented in the form of a software product. The software product is stored in a storage medium, and includes several instructions for instructing a computer device (which may be a personal computer, a server, a network device, or the like) to execute all or some of the steps of the methods described in the embodiments of the present disclosure. The foregoing storage medium includes: any medium that can store program code, such as a USB flash drive, a removable hard disk, a read-only memory (ROM), a random access memory (RAM), a magnetic disk, or an optical disk.

Although some embodiments of the present disclosure are described above with reference to the accompanying drawings, these embodiments are not intended to limit the protection scope of the embodiments of the present disclosure. Any modifications, equivalent replacements and improvements made by those having ordinary skills in the art without departing from the scope and essence of the embodiments of the present disclosure shall fall within the protection scope of the embodiments of the present disclosure.

## Claims

1. A wind speed data prediction method, comprising:
acquiring three-dimensional spatial coordinates of a plurality of wind speed stations in a prediction scenario, and constructing a continuous spatio-temporal graph sequence in the prediction scenario based on the plurality of three-dimensional spatial coordinates (101), wherein the continuous spatio-temporal graph sequence comprises an adjacency matrix, the continuous spatio-temporal graph sequence does not comprise wind speed station data of a missing wind speed station, and the adjacency matrix comprises weight adjacency elements between the missing wind speed station and other wind speed stations;
inputting the continuous spatio-temporal graph sequence into a spatio-temporal graph attention network, and sequentially performing node relationship attention processing on the wind speed station data of the missing wind speed station based on the weight adjacency elements through a plurality of graph attention layers cascaded to obtain a complete spatio-temporal graph sequence (102), wherein the complete spatio-temporal graph sequence comprises the wind speed station data of the missing wind speed station; and
inputting the complete spatio-temporal graph sequence into a wind speed prediction model for data processing to obtain a wind speed data prediction result of the prediction scenario (103).

2. The wind speed data prediction method of claim 1, wherein constructing a continuous spatio-temporal graph sequence in the prediction scenario based on the plurality of three-dimensional spatial coordinates comprises:
performing a weighted summation operation based on the three-dimensional spatial coordinates and directional weights of every two of the wind speed stations to obtain edge features between every two of the wind speed stations (201);
performing percentage processing on differences between the three-dimensional spatial coordinates of every two of the wind speed stations to obtain graph connection thresholds (202); and
obtaining the continuous spatio-temporal graph sequence based on the graph connection thresholds and the edge features (203).

3. The wind speed data prediction method of claim 2, wherein obtaining the continuous spatio-temporal graph sequence based on the graph connection thresholds and the edge features (203) comprises:
in response to the differences between the three-dimensional spatial coordinates of every two of the wind speed stations respectively not exceeding the graph connection thresholds, obtaining the weight adjacency elements of every two of the wind speed stations based on reciprocals of the edge features, and combining all of the weight adjacency elements to obtain an adjacency matrix (301);
obtaining a degree matrix based on a sum of elements of each column in the adjacency matrix (302);
performing normalization processing based on the degree matrix to obtain a graph structure (303); and
combining graph structures corresponding to a plurality of consecutive moments to obtain the continuous spatio-temporal graph sequence (304).

4. The wind speed data prediction method of claim 1, wherein a process of training the spatio-temporal graph attention network comprises:
acquiring a plurality of training spatio-temporal graph sequences (501), wherein each of the training spatio-temporal graph sequences comprises data of a plurality of stations, missing station data, an adjacency weight matrix between a missing station and other stations, and station label data corresponding to the missing station data;
generating a node feature vector based on the missing station data, and constructing a node feature update function of each of the graph attention layers in the spatio-temporal graph attention network based on the node feature vector, the adjacency matrix, and an attention parameter of the spatio-temporal graph attention network (502);
constructing a loss function based on a data difference between the node feature vector and the station label data (503); and
iteratively updating a network parameter of the spatio-temporal graph attention network and the node feature vector based on the node feature update function and the loss function (504), wherein the network parameter updated by multiple iterations is used for node relationship attention processing on the continuous spatio-temporal graph sequence.

5. The wind speed data prediction method of claim 4, wherein generating a node feature vector based on the missing station data, and constructing a node feature update function of each of the graph attention layers in the spatio-temporal graph attention network based on the node feature vector, the adjacency matrix, and an attention parameter of the spatio-temporal graph attention network (502) comprises:
calculating a sum of the attention parameter between the missing station and each other station, and multiplying the sum by the adjacency weight matrix and the node feature vector of a previous graph attention layer to obtain a node feature update term (601); and
performing activation function processing based on the node feature update item to obtain the node feature update function of a current graph attention layer (602).

6. The wind speed data prediction method of claim 4, wherein constructing a loss function based on a data difference between the node feature vector and the station label data (503) comprises:
multiplying a 2-norm of an edge weight matrix between nodes by a regularization coefficient to obtain an edge weight norm (701);
performing averaging processing on 2-norms of all the data differences to obtain a data difference norm (702); and
accumulating the edge weight norm and the data difference norm to obtain the loss function (703).

7. The wind speed data prediction method of claim 4, wherein iteratively updating a network parameter of the spatio-temporal graph attention network and the node feature vector based on the node feature update function and the loss function (504) comprises:
performing relational attention processing on input data using the node feature update function of the graph attention layer to obtain output data (801), wherein input data of the first graph attention layer is the node feature vector, input data of each of graph attention layers other than the first graph attention layer is output data of a graph attention layer previous to the each of graph attention layers, and output data of a last graph attention layer is reconstructed station data of the missing station; and
updating the network parameter of the graph attention layer based on the output data and the loss function (802).

8. The wind speed data prediction method of claim 1, wherein inputting the complete spatio-temporal graph sequence into a wind speed prediction model for data processing to obtain a wind speed data prediction result of the prediction scenario (103) comprises:
decomposing the complete spatio-temporal graph sequence in the wind speed prediction model by a wavelet transform, followed by respective addition of placeholders at ends of sequences obtained from the decomposition, to obtain a trend component and a frequency component (1701);
performing embedding processing on the trend component and the frequency component to obtain an embedded node feature, and obtaining graph structure data based on the embedded node feature and an embedded edge feature (1702); and
inputting the graph structure data into a graph neural network for forward propagation processing to obtain the wind speed data prediction result (1703).

9. An electronic device, comprising a memory (2402) and a processor (2401), wherein the memory (2402) is configured for storing a computer program which, when executed by the processor (2401), causes the processor (2401) to perform the wind speed data prediction method of any one of claims 1-8.

10. A computer-readable storage medium, having a computer program stored thereon, wherein the computer program, when executed by a processor, causes the processor to perform the wind speed data prediction method of any one of claims 1-8.
